## Europäisches Patentamt
## European Patent Office
## Office européen des brevets

(19)

(11) Numéro de publication: **0 058 587**
**A1**

(12)
# DEMANDE DE BREVET EUROPEEN

(21) Numéro de dépôt: **82400143.2**

(22) Date de dépôt: **26.01.82**

(51) Int. Cl.³: **G 10 K 11/36**
**H 03 H 2/00**

(30) Priorité: **13.02.81 FR 8102865**

(43) Date de publication de la demande:
**25.08.82 Bulletin 82/34**

(84) Etats contractants désignés:
**DE GB NL SE**

(71) Demandeur: **THOMSON-CSF**
**173, Boulevard Haussmann**
**F-75360 Paris Cedex 08(FR)**

(72) Inventeur: **Volluet, Gérard**
**THOMSON-CSF SCPI 173, bld Haussmann**
**F-75360 Paris Cedex 08(FR)**

(72) Inventeur: **Hartemann, Pierre**
**THOMSON-CSF SCPI 173, bld Haussmann**
**F-75360 Paris Cedex 08(FR)**

(74) Mandataire: **Wang, Pierre et al,**
**THOMSON-CSF SCPI 173, Bld Haussmann**
**F-75360 Paris Cedex 08(FR)**

(54) Dispositif dioptrique à ondes magnétostatiques.

(57) L'invention se rapporte aux dispositifs à ondes magnétostatiques.

L'invention a pour objet un dispositif à ondes magnétostatiques dont la couche magnétique épitaxiée (2) a subi une implantation ionique (15) localisée à des plages (14) permettant de réfléchir et de réfracter les ondes magnétostatiques.

L'invention s'applique notamment à des structures réflectrices, focalisatrices et de guidage pour ondes magnétostatiques.

FIG.4

EP 0 058 587 A1

Croydon Printing Company Ltd.

# DISPOSITIF DIOPTRIQUE A ONDES MAGNETOSTATIQUES

La présente invention se rapporte aux dispositifs à ondes magnétostatiques comportant une couche ou une plaquette mince de matériau magnétique soumise à un champ magnétique externe. Lorsqu'on modifie dans des plages déterminées la vitesse de propagation des ondes magnétostatiques, on forme comme en optique des dioptres qui peuvent réfléchir partiellement, réfracter ou guider ces ondes. Au moyen d'un ruban conducteur parcouru par un courant alternatif de fréquence élevée, on peut exciter dans une couche magnétique polarisée des modes d'ondes de spin et des ondes magnétostatiques.

L'excitation sélective d'ondes magnétostatiques permet de réaliser des dispositifs qui présentent une certaine similitude avec d'autres dispositifs connus tels que les dispositifs à ondes élastiques de surface. Toutefois, la propagation d'ondes magnétostatiques peut être accompagnée de phénomènes d'absorption indésirables dûs à un couplage résiduel possible avec des modes d'ondes de spin. Lorsqu'on réalise une couche ou une plaquette magnétique d'épaisseur suffisante, cette couche étant par exemple obtenue par croissance épitaxiale sur un substrat non magnétique, on peut échanger des ondes magnétostatiques entre des transducteurs en micro-ruban sans être gêné par le spectre d'ondes de spin. Cette technique a donné naissance à des dispositifs d'ondes magnétostatiques capables de fonctionner dans une bande de fréquence étendue.

Dans les dispositifs à propagation d'onde, on a proposé diverses solutions pour créer un changement de vitesse de propagation dans des plages sélectionnées d'un substrat parcouru par des ondes. Ces solutions permettent de réaliser un guidage par réflexion totale, une focalisation par réfraction ou une simple réflexion d'onde.

Dans le cas des ondes magnétostatiques, un tel changement de vitesse d'onde peut être obtenu en creusant la surface de la couche ou de la plaquette magnétique dans des plages déterminées. La réduction d'épaisseur de la couche magnétique abaisse la vitesse de propagation. L'inconvénient d'un tel usinage est que les parties amincies favorisent l'excitation des modes d'ondes de spin en raison des perturbations existant dans les régions gravées. Pour réaliser un changement de vitesse d'onde qui ne donne pas naissance à l'excitation d'ondes de spin, on a proposé de localiser les plages où ce changement doit être réalisé par un revêtement métallique de la couche ou de la plaquette magnétique. Cette solution fournit un accroissement de la vitesse de propagation, mais elle présente l'inconvénient d'introduire des pertes de transmission importantes. On peut cependant diminuer l'effet atténuateur d'un revêtement métallique en l'éloignant de la couche magnétique, mais cette amélioration nécessite un processus de fabrication plus complexe. En vue de pallier les inconvénients mentionnés ci-dessus l'invention propose d'utiliser l'implantation ionique pour diminuer localement les propriétés magnétiques d'un milieu magnétique. L'absence d'usinage en creux et la suppression d'un revêtement métallique permettant d'obtenir par réduction d'épaisseur effective un abaissement de vitesse de propagation sans excitation d'ondes de spin et sans affaiblissement de transmission.

L'invention a pour objet un dispositif dioptrique à ondes magnétostatiques comportant un milieu magnétique, des moyens étant prévus pour exciter électriquement lesdites ondes et ledit milieu comprenant sur le trajet desdites ondes au moins une plage dans laquelle la vitesse de propagation desdites ondes est modifiée, caractérisé en ce que ladite plage est une plage ayant subi une implantation ionique.

L'invention sera mieux comprise au moyen de la description ci-après et des figures annexées parmi lesquelles :

- la figure 1 représente un dispositif à ondes magnétostatiques de type connu ;

- la figure 2 est une vue en coupe partielle du dispositif de la figure 1 ;

- la figure 3 représente une caractéristique de transmission par ondes magnétostatiques affectée de modes d'absorption par couplage d'ondes de spin ;

- la figure 4 est une vue en coupe d'un réseau à réflexion sélective selon l'invention ;

- la figure 5 est une vue isométrique d'une ligne à retard dispersive selon l'invention ;

- la figure 6 illustre les pertes d'insertion obtenues lors d'un échange par ondes magnétostatiques avec renvoi à angle droit par un réseau implanté ;

- la figure 7 montre une couche magnétique implantée avec effet de lentille et confinement dans un guide d'onde ;

- la figure 8 montre une couche implantée permettant de former une cavité résonante à miroirs.

Il est connu qu'une onde franchissante la limite séparant deux milieux de propagation se réfléchit et se réfracte. Dans le cas d'ondes magnétostatiques, le changement de milieu est lié à une altération de la couche magnétique ou à une interaction de celle-ci avec une structure conductrice voisine. Ainsi, un dispositif dioptrique à ondes magnétostatiques peut mettre en oeuvre une réflexion partielle, une réflexion totale ou un phénomène de réfraction. Ces trois effets s'appliquent à trois types d'ondes magnétostatiques susceptibles de se propager à la surface d'une plaquette ferrimagnétique. Dans ce cadre général, on s'intéresse à des plages introduisant un saut d'indice et les dioptres ainsi formés ont une action réflectrice et réfringente sur les ondes magnétostatiques.

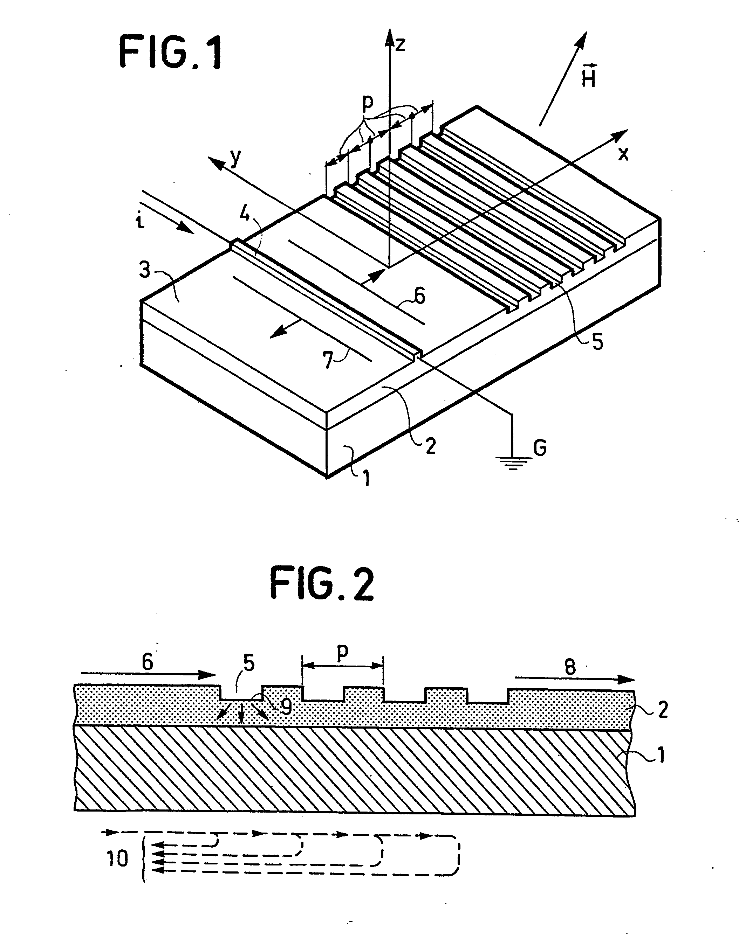

La figure 1 est une vue isométrique d'un dispositif dioptrique à ondes magnétostatiques mettant en oeuvre la réflexion sélective par un réseau périodique. D'une manière connue, et à titre d'exemple non limitatif, ce dispositif comporte un substrat non magnétique 1 en grenat de gadolinium et gallium (GGG) orienté 111 et une couche magnétique 2 de grenat d'yttrium et de fer (YIG) épitaxiée sur le substrat. L'épaisseur de la couche 2 peut varier entre quelques microns et quelques dizaines de microns. La couche 2 est soumise à un champ magnétique externe $\overrightarrow{H}$ dont l'orientation par rapport au système d'axes x, y, z de la figure 1 définit les modes d'ondes magnétostatiques susceptibles de se propager.

On peut avoir par exemple des ondes magnétostatiques de volume progressives (OMSVF) si le champ H est parallèle à l'axe z. Dans ce cas, la propagation est isotrope. On peut avoir aussi des ondes magnétostatiques de volume contra-progressives (OMSVB), si le champ H est orienté parallèlement à l'axe x selon lequel ces ondes se propagent. Enfin, si le champ H est orienté selon l'axe y ce sont des ondes magnétostatiques de surface (OMSS) qui se propagent dans la direction de l'axe x.

On voit sur la figure 1 un transducteur d'ondes magnétostatiques constitué par un ruban conducteur 4 déposé à la surface 3 de la couche magnétique 2.

Ce ruban conducteur orienté selon l'axe y est relié par l'une de ses extrémités à un plan de masse G. Un courant alternatif 6 est injecté par l'autre extrémité du ruban 4, afin d'exciter dans la couche magnétique 2 des ondes magnétostatiques dont les fronts d'ondes 6 et 7 s'éloignent du ruban conducteur 4.

Afin de réfléchir sélectivement le front d'onde 6, on a pratiqué dans la couche 2 un réseau de sillons parallèles 5 ayant un pas p uniforme. Chacun des sillons 5 est obtenu par enlèvement de matière en attaquant chimiquement la couche magnétique 2 ou en la creusant par usinage ionique.

La figure 2 est une coupe partielle du dispositif de la figure 1. Elle montre la section des sillons 5, le pas p du réseau réflecteur et la direction d'incidence G des ondes magnétostatiques. En aval du réseau de sillons 5 une fraction 8 de l'énergie des ondes magnétostatiques se propage dans la couche magnétique 2. Une série de trajets en pointillé illustre sur la figure 2 l'effet réflecteur du réseau de sillons 5. La fraction 10 de l'énergie réfléchie par le réseau est maximale lorsque le pas p est égal à la longueur d'onde $\lambda$ des ondes magnétostatiques reçues sous incidence normale. Dans le cas d'une incidence oblique, le maximum de pouvoir réflecteur se produit pour une excitation équiphase des différents traits 5 du réseau. Ainsi pour une incidence à 45° le maximum de réflexion a lieu lorsque le pas est égal à $\lambda/\sqrt{2}$ si l'onde magnétostatique est une onde de volume progressive.

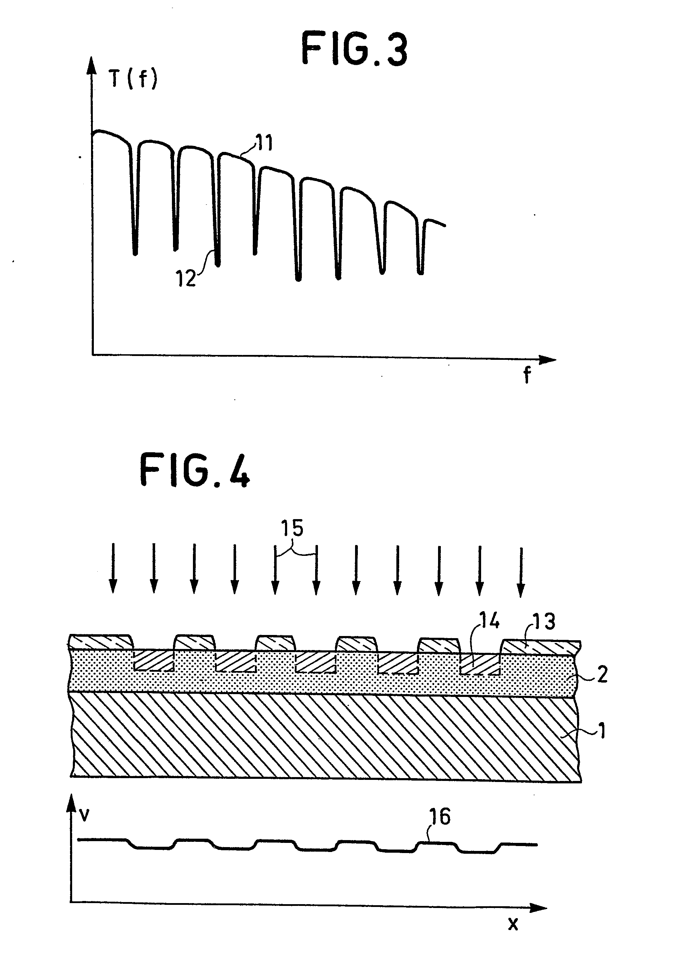

Si l'on recueille le rayonnement 8 transmis par le réseau de traits 5 ou le rayonnement 10 réfléchi sur un ruban conducteur analogue au ruban 4, un courant i' est induit par effet transducteur inverse et si l'on mesure le rapport $T = i'/i$ à différentes fréquences f on peut tracer un diagramme tel que représenté sur la figure 3. La courbe 11 renferme une série de pics 12 indiquant un couplage avec des modes d'onde de spin. Ce couplage peut être attribué au fond 9 des sillons 5 tel qu'il a été usiné. L'existence des pics 12 implique une limitation sévère de la bande de fréquence dans laquelle on peut mettre en oeuvre les propriétés de réflexion sélective d'un réseau ou toute autre propriété fondée sur des dioptres pour ondes magnétostatiques.

L'expérience a montré que la création de dioptres dans une couche ou une plaquette magnétique est exempte du défaut qui vient d'être signalé, lorsqu'on recouvre la surface de plages métalliques en forme de bandes ou de plots. Cependant, la présence de ces plages métalliques occasionne des pertes de transmission importantes.

Pour pallier cet inconvénient l'invention prévoit de former dans la couche 2 des dioptres par implantation ionique. L'expérience montre que cette technique permet d'obtenir de faibles pertes d'insertion et un couplage insignifiant vis à vis des modes d'ondes de spin.

Cette technique est illustrée sur la figure 4 qui montre à titre d'exemple non limitatif un masque de résine 13 déposé à la surface de la couche magnétique 2. Un bombardement ionique représenté par les flèches 15 assure l'implantation ionique de régions 14 délimitées en étendue par des orifices du masque de résine 13. La profondeur des régions 14 dépend de l'énergie des ions et de leur nature. Le masque de résine 13 est confectionné par les techniques bien connues de photolithographie et il peut être éliminé après implantation ionique.

On constate que les régions implantées 14 de la couche 2 sont dégénérées du point de vue magnétique et se comportent comme des zones amorphes. La transformation de la couche magnétique qui se produit à l'aplomb des zones implantées produit la modulation spatiale de vitesse de propagation v des ondes magnétostatiques comme l'illustre la courbe 16. En fait, l'implantation ionique ne donne naissance à aucun relief mesurable à la surface de la couche 2 et l'on constate qu'elle ne favorise pas le couplage avec les modes d'onde de spin. La profondeur des zones 14 rendues amorphes est de l'ordre du millier à quelques milliers d'angströms et le matériau magnétique y présente une aimantation fortement diminuée. Les zones implantées peuvent être localement paramagnétiques. L'abaissement de vitesse de propagation va de pair avec l'épaisseur effective de la couche magnétique, mais le fait de réduire localement cette épaisseur effective par implantation ne conduit pas au couplage indésirable signalé à propos de la gravure par enlèvement de matière qu'elle soit chimique ou ionique. On est donc en mesure d'obtenir dans une couche magnétique des dioptres à faibles

6

pertes d'insertion tout en évitant d'engendrer des résonances de modes de spin.

A titre d'exemple non limitatif, l'efficacité de l'implantation d'ions a été vérifiée pour effectuer une réflexion sélective d'ondes magnétostatiques de volume progressives.

En passant d'une couche monocristalline ferrimagnétique de grenat d'yttrium et de fer épitaxiée en phase liquide sur un grenat de gadolinium et gallium, on a déposé une résine de masquage, en l'occurence la résine 1350H produite par la firme SHIPLEY. La couche 2 ainsi masquée présentait une épaisseur de 23,5 µm. Par insolation et développement un réseau de quinze fenêtres rectangulaires a été ouvert dans la résine. Chaque fenêtre mesurant 7 mm de long et 50 µm de large était séparée de ses voisines par 50 µm de résine. Les conditions d'implantation étaient les suivantes :

nature de l'ion : $He^{4+}$

énergie d'accélération : 100 KeV

dose : $10^{16}$ ions/cm$^2$

densité de courant : 0,8 µA/cm$^2$.

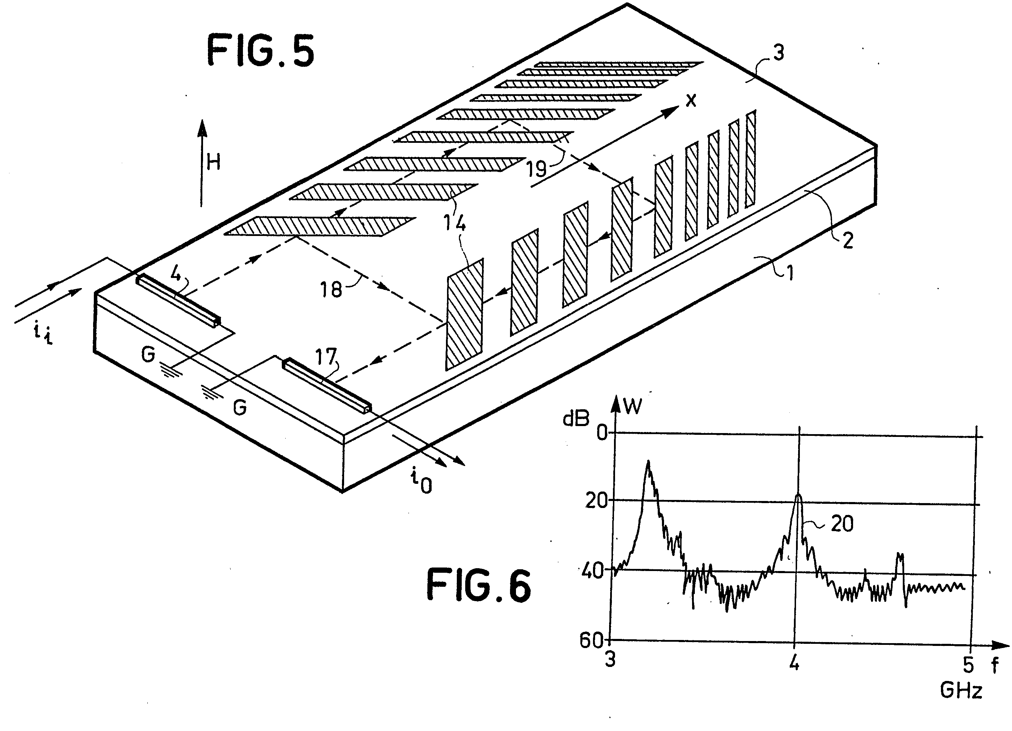

Un essai de transmission entre un microruban émetteur et un microruban récepteur effectué par réflexion sélective à 45° a fourni le relevé de la figure 6 qui donne en décibel les pertes d'insertion W en fonction de la fréquence f des ondes magnétostatiques. La région 20 de la courbe montre nettement cette réflexion sélective autour de la fréquence 4GHz avec une absence remarquable de résonances de modes de spin.

La figure 5 représente une ligne dispersive basée sur la réflexion sélective des ondes magnétostatiques. Elle comporte une couche magnétique 2 épitaxiée sur un substrat 1. Un champ magnétique externe H polarise la couche 2 perpendiculairement à sa surface. Des ondes magnétostatiques sont excitées dans la direction x par un courant $i_i$ circulant dans le microruban 4. Un microruban 17 capte les ondes magnétostatiques après deux réflexions sélectives se produisant sur deux jeux de plages implantées 14. A cet effet, les plages 14 forment deux réseaux de traits inclinés à 45° en sens contraires par rapport à la direction de propagation x. Les espacements des traits varient de la même façon dans la direction x, afin que le retard de transmission entre le courant $i_o$ et le courant $i_i$ soit fonction de la fréquence. Dans un cas typique de caractéristique de dispersion à réaliser, on peut faire en sorte qu'aux fréquences basses les ondes magnétostatiques décrivent un trajet 18 plus court que le trajet 19 emprunté par les ondes de fréquence plus élevée. Il est à noter que les traits des réseaux peuvent être subdivisés en chapelets de plots.

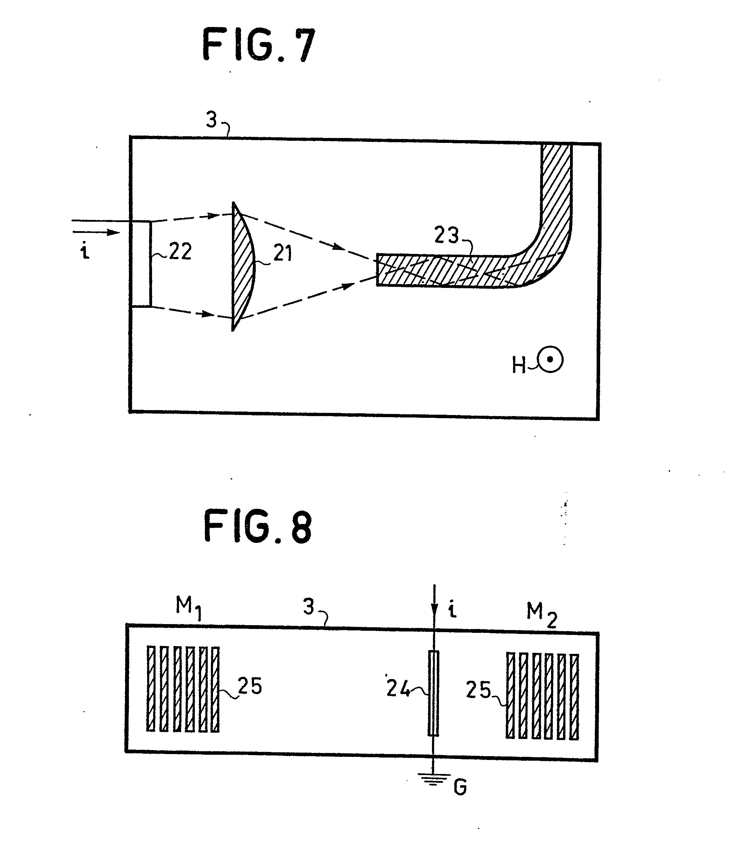

La figure 7 illustre une application de l'invention à la focalisation et au guidage des ondes magnétostatiques. La face supérieure 3 de la couche magnétique est située dans le plan de figure et le champ magnétique externe H est sensé être dirigé perpendiculairement à ce plan.

Les ondes magnétostatiques sont excitées par un microruban 22 parcouru par le courant alternatif i. Il rayonne vers la droite des fronts d'ondes rectilignes reçus par une plage implantée 21 de forme lenticulaire. Le ralentissement subi par les ondes magnétostatiques qui franchissent la plage 21 entraine leur focalisation à l'entrée d'une autre plage implantée 23. Comme les ondes se propagent plus lentement à l'intérieur de la plage 23, elles peuvent subir une réflexion totale sur les deux dioptres équidistants qui bornent cette plage implantée. La plage 23 assure donc la fonction d'un guide d'onde. Faute de place, la courbure du guide d'onde 23 a été fortement exagérée.

La zone 23 peut présenter une largeur non-uniforme. Ainsi, on peut prévoir une entrée évasée semblable à un entonnoir. On peut aussi donner à la zone 23 une forme en Y, c'est à dire une disposition étoilée à plusieurs branches. En reliant deux structures en Y par deux branches, on peut réaliser un interféromètre intégré à deux bras. L'invention s'applique également aux lentilles zonées et aux lentilles de Fresnel.

Sur la figure 8, on a représenté une cavité de résonance à miroirs $M_1$ et $M_2$. Les miroirs sont constitués par des réseaux 25 implantés à la surface 3 de la couche magnétique. On a représenté à l'intérieur de la cavité un microruban 24 dont l'impédance dépend des modes de résonance de la cavité. On peut relier le microruban 24 à un circuit électrique à résistance négative pour obtenir un oscillateur. Les réseaux 25 peuvent occuper tout l'espace disponible et ne plus former qu'un seul réseau. Dans ce cas, le microruban 24 peut être imbriqué entre deux zones implantées. On peut aussi déposer deux microrubans dans la cavité, dans ce cas la fonction de transfert entre ces

8

deux transducteurs présente un maximum, à la fréquence de résonance.

L'invention s'applique à toute configuration mettant en oeuvre des dioptres réflecteurs ou réfringents à la surface d'un milieu magnétique. L'implantation ionique crée une diminution locale d'aimantation qui à l'instar d'un usinage avec enlèvement de matière n'altère pas la surface et par conséquent ne favorise pas le couplage avec des modes parasites, Les pertes de propagation sont négligeables dans les plages implantées et l'effet de l'implantation peut être dosé en jouant sur le choix des ions, sur l'énergie d'impact et sur la dose reçue. Comme la surface de la couche magnétique reste sensiblement plane, on peut faire chevaucher une plage implantée par des microrubans conducteurs. Cette possibilité permet grâce à la réduction des propriétés magnétiques de pondérer en amplitude l'émissivité des microrubans. Deux plages non-contigues peuvent délimiter une plage intermédiaire ayant conservé ses propriétés magnétiques et des microrubans peuvent chevaucher ces trois plages de façon à déterminer des zones d'émissivités différenciées. Des microrubans en court circuit peuvent réaliser un couplage entre deux guides d'ondes implantés. En l'absence de microrubans, deux guides d'ondes rapprochés peuvent former un coupleur directionnel.

REVENDICATIONS

1. Dispositif dioptrique à ondes magnétostatiques comportant un milieu magnétique (2), des moyens (4) étant prévus pour exciter électriquement lesdites ondes et ledit milieu comprenant sur le trajet desdites ondes au moins une plage dans laquelle la vitesse de propagation desdites ondes est modifiée, caractérisé en ce que ladite plage est une plage (14) ayant subi une implantation ionique (15).

2. Dispositif selon la revendication 1, caractérisé en ce qu'il comporte au moins un ensemble de plages implantées (14) formant un réseau à réflexion sélective.

3. Dispositif selon la revendication 2, caractérisé en ce que ce réseau forme un résonateur à ondes magnétostatiques.

4. Dispositif selon la revendication 2, caractérisé en ce qu'il comprend au moins deux réseaux à réflexion sélective échangeant lesdites ondes magnétostatiques.

5. Dispositif selon la revendication 4, caractérisé en ce que l'échange a lieu selon un trajet perpendiculaire aux traits des réseaux afin de former un résonateur.

6. Dispositif selon la revendication 4, caractérisé en ce que l'échange a lieu selon des trajectoires obliques (18, 19) par rapport aux traits des réseaux.

7. Dispositif selon la revendication 1, caractérisé en ce que ladite plage forme un guide d'onde (23).

8. Dispositif selon la revendication 1, caractérisé en ce que ledit guide comporte plusieurs branches.

9. Dispositif selon la revendication 1, caractérisé en ce que ladite plage présente une configuration (21) modifiant la vergence des ondes magné tostatiques.

10. Dispositif selon l'une quelconque des revendications précédentes, caractérisé en ce que les moyens d'excitation (4) comprennent au moins un microruban conducteur rayonnant en direction de ladite plage (14).

11. Dispositif selon l'une quelconque des revendications 1 à 9, caracté-

10

risé en ce que les moyens d'excitation (4) comprennent au moins un microruban conducteur recouvrant ladite plage (14).

12. Dispositif selon l'une quelconque des revendications 1 à 11, caractérisé en ce que lesdites ondes magnétostatiques sont de l'un des modes suivants : ondes magnétostatiques de volume progressives, ondes magnétostatiques de volume contra-progressives, ondes magnétostatiques de surface.

13. Dispositif selon la revendication 2, caractérisé en ce que les traits dudit réseau sont constitués par des chapelets de plots.

14. Dispositif selon l'une quelconque des revendications précédentes, caractérisé en ce que ledit milieu (2) est une couche magnétique épitaxiée sur un substrat (1).

**FIG.1**

**FIG.2**

# FIG.3

# FIG.4

FIG.5

FIG.6

# FIG.7

# FIG.8

0058587

Office européen
des brevets

## RAPPORT DE RECHERCHE EUROPEENNE

Numéro de la demande

EP 82 40 0143

| | DOCUMENTS CONSIDERES COMME PERTINENTS | | CLASSEMENT DE LA DEMANDE (Int. Cl. 3) |
|---|---|---|---|
| Catégorie | Citation du document avec indication, en cas de besoin, des parties pertinentes | Revendication concernée | |
| X,Y | <u>FR - A - 2 249 491</u> (THOMSON-CSF)<br><br> * page 3, ligne 11 à page 4, ligne 9; page 5, ligne 15 à page 6, ligne 22; page 7, ligne 21 à page 9, ligne 7; figures 1-8 *<br><br> -- | 1,7,9 | G 10 K 11/36<br>H 03 H 2/00 |
| Y | <u>EP - A - 0 021 878</u> (THOMSON-CSF)<br><br> * page 5, ligne 13 à page 6, ligne 35; figures 2-5 *<br><br> -- | 1-5,14 | |
| Y | 1979 INTERNATIONAL SYMPOSIUM ON CIRCUITS AND SYSTEMS PROCEEDINGS, 17-19 juillet 1979<br>IEEE Catalog no. 79 CH1421-7 CAS<br>TOKYO (JP)<br>J.M. OWENS et al. "Surface acoustic wave and magnetostatic wave devices: a status report" pages 568-571<br><br> * page 569, alinéa 2, colonne de gauche à dernier alinéa, colonne de droite; figure 4 *<br><br> -- | 2-6,12, 14 | DOMAINES TECHNIQUES RECHERCHES (Int. Cl. 3)<br><br>G 10 K<br>H 03 H |
| Y | <u>FR - A - 2 250 230</u> (THOMSON-CSF)<br><br> * page 2, ligne 15 à page 3, ligne 21; figures 1-5 *<br><br> -- | 1,9,13 | CATEGORIE DES DOCUMENTS CITES |
| A | <u>US - A - 3 409 848</u> (MEITZLER et al.)<br><br> * colonne 4, lignes 28 à 55; figure 5 *<br><br> -- ./. | 7,8 | X: particulièrement pertinent à lui seul<br>Y: particulièrement pertinent en combinaison avec un autre document de la même catégorie<br>A: arrière-plan technologique<br>O: divulgation non-écrite<br>P: document intercalaire<br>T: théorie ou principe à la base de l'invention<br>E: document de brevet antérieur, mais publié à la date de dépôt ou après cette date<br>D: cité dans la demande<br>L: cité pour d'autres raisons<br><br>&: membre de la même famille, document correspondant |

| X | Le présent rapport de recherche a été établi pour toutes les revendications |
|---|---|

| Lieu de la recherche<br>La Haye | Date d'achèvement de la recherche<br>05-04-1982 | Examinateur<br>STÜBNER |
|---|---|---|

OEB Form 1503.1 06.78

**Office européen des brevets**

**RAPPORT DE RECHERCHE EUROPEENNE**

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendica-tion concernée | |
| A | ELECTRONICS INTERNATIONAL, volume 53, no. 11, mai 1980 NEW YORK (US) J.D. ADAM et al. "Magnetostatic-wave devices move microwave design into gigahertz realm" pages 123-128  * en entier * | | |

DOMAINES TECHNIQUES RECHERCHES (Int. Cl.³)